Europäisches Patentamt

**European Patent Office**

**Office européen des brevets**

(11) Veröffentlichungsnummer: **0 278 382**
**A2**

(12) **EUROPÄISCHE PATENTANMELDUNG**

(21) Anmeldenummer: **88101554.9**

(51) Int. Cl.⁴: **H05K 9/00**

(22) Anmeldetag: **03.02.88**

(30) Priorität: **06.02.87 AT 244/87**

(43) Veröffentlichungstag der Anmeldung:
**17.08.88 Patentblatt 88/33**

(84) Benannte Vertragsstaaten:
**AT DE NL**

(71) Anmelder: **SIEMENS AKTIENGESELLSCHAFT
ÖSTERREICH**
**Siemensstrasse 88-92**
**A-1210 Wien(AT)**

(84) **AT**

(71) Anmelder: **SIEMENS AKTIENGESELLSCHAFT**
**Postfach 22 02 61**
**D-8000 München 22(DE)**

(84) **DE NL**

(72) Erfinder: **Stockinger, Helmut**
**Russbergstrasse 20/3**
**A-1210 Wien(AT)**

(54) **Sperrfilter.**

(57) Sperrfilter für den Einsatz in an Gemeinschaftsantennen angeschlossene Teilnehmerkabel,
bei dem die Filterbauteile (7,8) auf einer Leiterplatte
(1) angeordnet und mit dieser zusammen in einem
Abschirmgehäuse (10) untergebracht sind. Störende
Längsströme zwischen der Leiterplatte (1) und dem
Abschirmgehäuse (10) die eine Verkopplung zwischen den Filterinduktivitäten (7) hervorrufen
könnten, werden erfindungsgemäß dadurch vermieden, daß die Leiterplatte (1) an ihren Längsseiten mit
das Grundpotential führenden Metalleisten (9,9') versehen ist, die mit dem Abschirmgehäuse durch
Lötung verbunden sind, wobei das Abschirmgehäuse (10) beidseitig mit mehreren
Öffnungen (11, 11') zur Aufnahme des Lotes versehen ist.

FIG 2

## Sperrfilter

Die Erfindung betrifft ein Sperrfilter für den Einsatz in an Gemeinschaftsantennen angeschlossene Teilnehmerkabel, bei dem die Filterbauteile auf einer Leiterplatte angeordnet und mit dieser zusammen in einem Abschirmgehäuse untergebracht sind, wobei die Leiterplatte mit das Grundpotential führenden Metallteilen verbunden ist.

Die Verbindung einer isolierenden Tragplatte für den Aufbau von Hochfrequenz-Bauelementen hoher Verlustleistung mit einer Platte aus Metallblech zum Zweck der Wärmeableitung ist durch die DE-OS 26 12 bekannt geworden.

Es ist weiters bekannt, an Gemeinschaftsantennenanlagen angeschlossene Teilnehmer, denen nicht alle Fernsehkanäle zugeführt werden sollen, durch den Einsatz von Sperrfiltern in ihren individuellen Teilnehmerkabeln vom Empfang der unerwünschten Fernsehkanäle auszuschließen. Die dafür zum Einsatz gelangenden Sperrfilter müssen demnach einerseits eine hohe Flankensteilheit und anderseites eine hohe Sperrdämpfung aufweisen.

Sperrfilter dieser Art bestehen üblicherweise aus mehreren in Serie geschalteten Induktivitäten, deren Verbindungsstellen über Kapazitäten und weitere Induktivitäten mit dem Grundpotential verbunden sind. Hierbei können störende Verkopplungen zwischen diesen Induktivitäten durch Ausgleichströme zustande kommen, die als Folge von ungleichmäßig über die Länge des Filters verteilten Übergangswiderständen zwischen den das Grundpotential führenden Teilen auf der Leiterplatte einerseits und der metallischen Abschirmung anderseits auftreten.

Die Erfindung hat sich daher die Aufgabe gestellt, solche störenden Inhomogenitäten des Übergangswiderstandes bei Verwendung von Leiterplatten, die mit das Grundpotential führenden Metallteilen verbunden sind, zu vermeiden und erzielt dies dadurch, daß die Metallteile als Metalleisten ausgeführt sind, die an den Längsseiten der Leiterplatten angebracht und mit dem Abschirmgehäuse durch Lötung verbunden sind, wobei das Abschirmgehäuse beidseitig mit mehreren Öffnungen zur Aufnahme des Lotes versehen ist.

Die Vorteile der erfindungsgemäßen Art der Lötverbindung zwischen diesen Metallteilen der Leiterplatte und dem Abschirmgehäuse bestehen darin, daß durch diese Metalleisten eine gleichmäßige Verteilung des Grundpotentials längs der ganzen Leiterplatte erzielt und damit das Auftreten von störenden Längsströmen verhindert wird, was noch dadurch unterstützt wird, daß das Abschirmgehäuse an mehreren Stellen mit den Metalleisten verlötet wird. Diese Lötverbindungen unterliegen auch keiner Korrosion, so daß sich auch die Störsicherheit im Laufe der Zeit nicht ändert.

Der Aufbau des erfindungsgemäßen Sperrfilters ermöglicht einen Filterabgleich vor dem Zusammenbau mit dem Abschirmgehäuse, der durch Verlöten nicht gestört werden kann. Zufolge der gleichmäßigen Masseverhältnisse erweist sich die Fertigung besonders einfach und wirtschaftlich.

Als Ausführungsbeispiel der Erfindung ist in der Zeichnung ein Sperrfilter in mehreren Ansichten und zum Teil im Schnitt dargestellt.

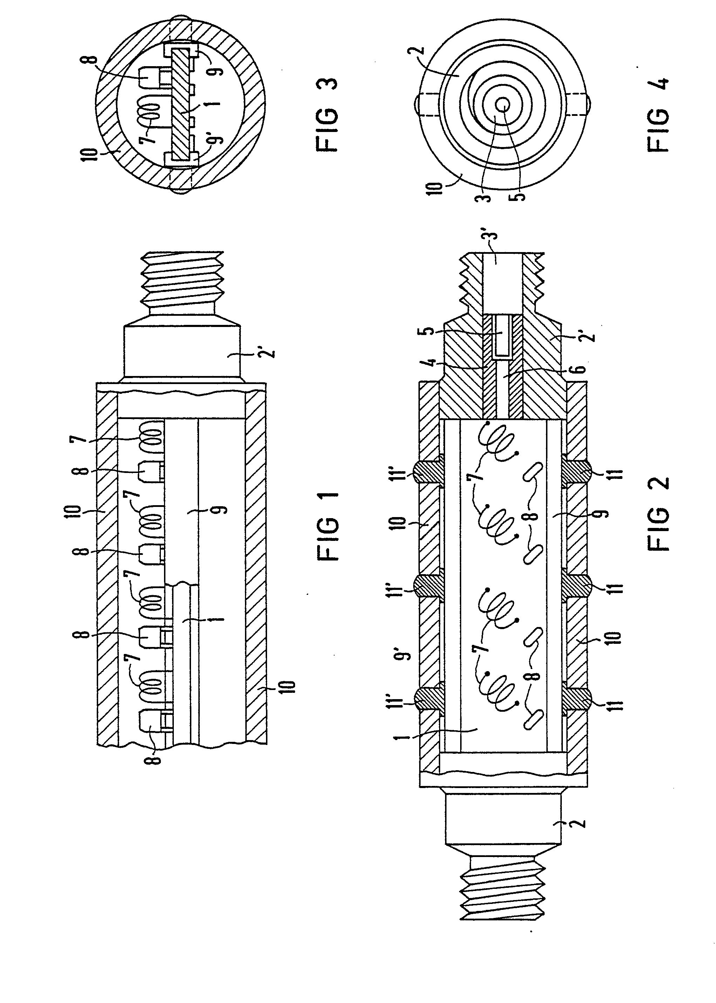

Die Teile des erfindungsgemäßen Sperrfilters sind im wesentlichen auf einer Leiterplatte 1 angeordnet, die in Fig. 1 von der Seite, in Fig. 2 von oben und in Fig. 3 im Querschnitt zu sehen ist. Fig. 4 zeigt die Stirnseite des Sperrfilters. Zur Einsetzung des Sperrfilters in ein Koaxialkabel ist dieses beidseitig mit je einem Verbindungsstück 2 bzw. 2' versehen. Die Verbindungsstücke 2,2' weisen Öffnungen 3,3' zum Einstecken der beiden offenen Enden des in der Zeichnung nicht dargestellten Koaxialkabels auf, wobei im Inneren der Einsecköffnungen, wie an Hand des in Fig. 2 im Schnitt dargestellten Verbindungsstückes 2' gezeigt, eine in einem Isolierstück 4 eingesetzte Buchse 5 zur Aufnahme des Innenleiters des Koaxialkabels vorgesehen ist, die über eine Leiterbahn 6 mit den spannungsführenden Teilen des Sperrfilters verbunden ist.

Schaltungsmäßig ist das Sperrfilter als Kettenfilter aufgebaut, das mehrere in Serie liegende Induktivitäten 7 aufweist, deren gemeinsame Verbindungsstellen über Kapazitäten 8 sowie über durch Leiterbahnen gebildete Induktivitäten an das Grundpotential geschaltet sind. Diese Leiterbahnen sowie die Lötstellen für die Anschlüsse der Induktivitäten 7 und der Kapazitäten 8 befinden sich wie aus Fig. 3 zu ersehen ist, auf der Unterseite der Leiterplatte 1. Die beiden Längsseiten der Leiterplatte 1 sind von zwei Metalleisten 9,9' eingefaßt, die durch Lötverbindungen mit allem am Grundpotential liegenden Anschlüssen aller Filterbauteile 7, 8 leitend verbunden sind.

Mit 10 ist ein als rohrförmiger Metallzylinder ausgebildetes Abschirmgehäuse bezeichnet, das über die bestückte Leiterplatte 1, nachdem diese mit den Verbindungsstücken 2 und 2' fest verbunden und verlötet worden ist, übergeschoben wird. Das Abschirmgehäuse 10 ist mit (im vorliegenden Beispiel drei) Paaren von einander gegenüberliegenden Öffnungen 11, 11' versehen, die beim Überschieben des Abschirmgehäuses 10 so gelegt werden, daß sie genau über die Metalleisten 9 bzw. 9' zu liegen kommen. Danach werden die Öffnungen 11 und 11' mit Lot ausgefüllt, das sich sowohl mit dem Metall des Abschirmgehäuses 10 als auch mit den Metalleisten sowhol kraft-und formschlüssig und damit auch in optimaler Weise elektrisch leitend verbindet.

Die Verbindungsstücke 2,2' sind mit Schraubgewinden für Überwurfmuttern versehen, die (gemeinsam mit Hülsen) die Kabelenden nach dem Einstecken in die Öffnung 3,3' fixieren. Über die Überwurfmutter wird eine Gummikappe geschoben als Schutz gegen Eindringen von Feuchtigkeit. Über das Abschirmgehäuse 10 sowie die Verbindungsstücke 2, 2' wird aus demselben Grund ein thermoplastischer Schrumpfschlauch geschoben und durch Erhitzen fixiert, der in der Zeichnung aber nicht dargestellt ist.

## Ansprüche

Sperrfilter für den Einsatz in an Gemeinschaftsantennen angeschlossene Teilnehmerkabel, bei dem die Filterbauteile auf einer Leiterplatte angeordnet und mit dieser zusammen in einem Abschirmgehäuse untergebracht sind, wobei die Leiterplatte mit das Grundpotential führenden Metallteilen verbunden ist, **dadurch gekennzeichnet,** daß die Metallteile als Metalleisten (9,9') ausgeführt sind, die an den Längsseiten der Leiterplatte (1) angebracht und mit dem Abschirmgehäuse (10) durch Lötung verbunden sind, wobei das Abschirmgehäuse (10) beidseitig mit mehreren Öffnungen (11, 11') zur Aufnahme des Lotes versehen ist.

87 P 7002

FIG 3

FIG 4

FIG 1

FIG 2